## Europäisches Patentamt
## European Patent Office
## Office européen des brevets

(19)

(11) Veröffentlichungsnummer: **0 001 038**
**B1**

(12) **EUROPÄISCHE PATENTSCHRIFT**

(45) Veröffentlichungstag der Patentschrift: **02.09.81**

(51) Int. Cl.³: **H 01 L 21/00, H 01 L 29/06**

(21) Anmeldenummer: **78100294.4**

(22) Anmeldetag: **03.07.78**

(54) Herstellung einer Siliciummaske und ihre Verwendung.

(30) Priorität: **05.07.77 US 812941**

(43) Veröffentlichungstag der Anmeldung:
**21.03.79 Patentblatt 79/6**

(45) Bekanntmachung des Hinweises auf die Patenterteilung:
**02.09.81 Patentblatt 81/35**

(84) Benannte Vertragsstaaten:
**DE FR GB**

(56) Entgegenhaltungen:
FR - A - 2 233 654
FR - A - 2 252 907
GB - A - 1 235 077
US - A - 4 021 276

(73) Patentinhaber: **International Business Machines Corporation**
**Armonk, N.Y. 10504 (US)**

(72) Erfinder: **Magdo, Ingrid Emese**
**Carpenter Road**
**Hopewell Junction New York 12533 (US)**
Erfinder: **Magdo, Steven**
**Carpenter Road**
**Hopewell Junction New York 12533 (US)**

(74) Vertreter: **Oechssler, Dietrich, Dr.rer.nat. Dipl.-Chem.**
**Schönaicher Strasse 220**
**D-7030 Böblingen (DE)**

Courier Press, Leamington Spa, England.

## Herstellung einer Siliciummaske und ihre Verwendung

Die Erfindung betrifft ein Verfahren zum Herstellen einer Maske aus Silicium, bei dem an der einen Oberfläche eines plättchenförmigen und planaren Substrats aus Silicium eine dunne Siliciumschicht erzeugt wird, deren Konzentration an die Leitfähigkeit bestimmenden Verunreinigungen höher als im Substrat ist, bei dem von der Substratoberfläche her, welche der höher dotierten Siliciums schicht entgegengesetzt ist, selektiv in das Substrat hinein Vertiefungen geätzt werden, und bei dem von der Oberfläche der dünnen, höher dotierten Schicht aus selektiv entsprechend dem gewünschten Maskenmuster bis zu den beim Ätzen des Substrats entstandenen Vertiefungen durchgehende Löcher geätzt werden, und die Verwendung einer solchen Maske.

Integrierte Schaltkreise werden üblicherweise unter Anwendung photolithographischer Fabrikationstechniken erzeugt. Dabei muß auf dem Substrat, in welchem die integrierte Schaltung entstehen soll, ein Photolackmuster vor jedem Fabrikationsschritt erzeugt werden, bei dem das Substrat nur in gemäß einem festgelegten Muster bestimmten Bereichen verändert wird. Bei der Herstellung integrierter Schaltungen kann das Photolackmuster verschiedenartige metallische Muster definieren, welche mittels photolithographischer Ätztechniken hergestellt werden, oder es kann dazu dienen, um Muster in isolierenden Schichten zu erzeugen, welche die Aufgabe haben, das Eindringen von die Leitfähigkeit bestimmenden Verunreinigungen in das Substrat zu begrenzen oder die Bereiche der elektrischen Isolation zu definieren.

Die Herstellung irgendwelcher ünblicher hochintegrierter Schaltungen, welche dem heutigen Stand der Technik entsprechen, erfordern Dutzende solcher photolithographischer Maskierungsschritte. Jeder dieser Maskierungsschritte ist komplex. Es ist nämlich zunächst notwendig, eine Maske zu erzeugen, welche von dem Substrat getrennt werden kann, und durch welche die Photolackschicht bestrahlt wird, wobei eine solche Maske beispielsweise eine konventionelle Metallmaske auf einem Glassubstrat sein kann. Nach dem Belichten des Photolacks muß er entwickelt werden. Hinzu kommt, daß jeder dieser Schritte, bei denen der Photolack belichtet wird, eine ziemlich schwierige Ausrichtung der Glasmaske zu dem Substrat erforderlich macht. Ein Teil der Schwierigkeit bei einer solchen Ausrichtung besteht darin, daß eine Ausrichtungsmarke auf dem Substrat zu einer entsprechenden Marke auf der Unterseite der Glasmaske ausgerichtet werden muß. Das Bild dieser Ausrichtungsindikatoren muß durch eine 1,27 bis 1,524 mm dicke Glasschicht hindurchgehen, bevor es die Objektivlinse des Ausrichtungsmikroskops erreicht. Dieser beachtliche Abstand zwischen der Ausrichtungsmarke und der Objektivlinse verursacht einen Abbildungsfehler bei der Ausrichtung. Außerdem muß das Bild des auf dem Substrat befindlichen Ausrichtungsindikators durch die Photolackschicht, welche das Substrat bedeckt, hindurchpassieren, was auch einen gewissen Abbildungsfehler verursacht, welcher auf eine Dispersion des Lichts in dem Photolak zurückzuführen ist.

Aus den genannten Gründen wäre es wünschenswert, ein Verfahren zum Herstellen von integrierten Schaltungen zu besitzen, bei welchem die Anwendung von photolithographischen Techniken eliminiert wäre und stattdessen die eine Maske erfordernden Fabrikationsschritte mit einer Maske, welche nach Gebrauch jeweils wieder vom Substrat abgehoben werden kann und welche dazu dienen würde, um das spezielle laterale geometrische Muster, welches bei diesem speziellen Verfahrensschritt für die notwendige Selektion bei der Bearbeitung sorgen soll, zu definieren, durchgeführt werden könnte. Silicium würde ein wünschenswertes Material für eine solche abhebbare Maske sein, da es einen identischen thermischen Ausdehnungskoeffizienten wie das Substrat hätte und deshalb eine Formveränderung der Maske während eines Verfahrensschritts, bei welchem die Anwendung von Wärme erforderlich ist, sich nicht ungünstig auswirken würde.

Die Anwendung von Siliciummasken bei der Herstellung von integrierten Schaltkreiselementen mittels lonenimplantation ist im US-Patent 3 713 922 offenbart. Jedoch haben solche Maskenstrukturen relativ kleine verwendbare Maskenbereiche oder Fenster aus dünnem Silicium, während ein wesentlicher Teil der Maske von einem Netz unterstützender Rippen aus dickem Silicium belegt ist. Wie in diesem Patent ausgeführt ist, haben die Fenster aus dünnem, d.h. ungefähr 1 $\mu$m dickem Silicium laterale Abmessungen von 50 bis 500 $\mu$m und werden unterstützt von einem Netz von Rippen, welche etwa 25,4 $\mu$m dick sind. Da jedoch übliche hochintegrierte Schaltkreise Chips erfordern, welche laterale Abmessungen in der Größenordung von 1250 bis 12 500 $\mu$m und sogar noch größer haben, scheint es so, daß die Strukturen, welche in dem Patent beschrieben werden, nicht in der Lage sind, Siliciummasken bereitzustellen, deren dünne Siliciumbereiche laterale Dimensionen in der Größenordnung von zwischen 1250 und 12 500 $\mu$m haben, was notwendig wäre, damit jedes Fenster ein ganzes Chip maskieren kann.

In der US-A-4 021 276 wird die Herstellung einer Siliciummaske beschrieben, welche auch bei der lonenimplantation eingesetzt werden soll. Bei dem in der genannten Patentschrift beschriebenen Verfahren wird zunächst an der einen Oberfläche eines plättchenförmigen und planaren Siliciumsubstrats eine dünne Siliciumschicht erzeugt, deren Konzentration an die Leitfähigkeit bestimmenden Verunreinigungen höher als im Substrat ist. Durch diese Dotierung wird erreicht, daß die Ätzbarkeit der dünnen Schicht sich von der des übrigen Substrats unterscheidet. Anschließend werden von der Substratoberfläche her, welche der höher dotierten Schicht entgegengesetzt ist, selektive mittels mechanischen Mitteln Vertiefungen in dem Substrat erzeugt. Dann wird von der Oberfläche der dünnen, höher dotierten Schicht selektiv entsprechend dem gewünschten Maskenmuster bis zu den beim Ätzen des Substrats entstandenen Vertiefungen durchgehende Löcher geätzt, und schließlich werden die Vertiefungen mittels eines Ätzmittels bis zu der dünnen Schicht vertieft. Bei diesem Verfahren ist nachteilig, daß das Maskenmuster in eine relativ dicke Schicht geätzt werden muß, was die Mustertreue, mit welcher das Muster übertragen wird, beeinträchtigt, und daß die Struktur nach dem Ätzen des Maskenmusters nocheinmal einem Ätzschritt unterworfen wird, bei welchem zwar nur wenig Material von der dünnen, höher dotierten Schicht abgetragen wird, jedoch immerhin soviel, daß die sehr feinen Musterelemente, welche für sehr hoch integrierte Schaltungen typisch sind, in unkontrollierter Weise verändert werden. Es kommt hinzu, daß das in der US-Patentschrift beschriebene Herstellungsverfahren kompliziert ist.

Es ist die Aufgabe der Erfindung, ein relativ einfaches Verfahren, um stabile, planare Silicummasken reproduzierbar und unter Einhaltung enger Toleranzen herzustellen, und Anwendungsmöglichkeiten für eine solche Maske, insbesondere bei der Herstellung von hochintegrierten und dicht gepackten Halbleiterschaltungen, anzugeben. Diese Aufgabe wird mit einem Verfahren gemäß dem Patentanspruch 1 und mit Verwendungsmöglichkeiten der Maske gemäß dem kennzeichnenden Teil des Anspruchs 9 gelöst. Die Merkmale des Oberbegriffs des Patantanspruchs 1 sind bekannt aus der US-A-4 021 276.

Bei der Herstellung der Maske gemäß dem erfindungsgemäßen Verfahren können die Schwankungen der Maskenabmessungen sehr klein gehalten werden. D.h., daß ein gemäß festgelegten Spezifikationen definiertes Maskenmuster mit sehr guter Mustertreue in das Maskenmaterial übertragen werden kann. Dies trifft auch zu, wenn wie es für die Herstellung hochintegrierter Schaltkreise notwendig ist, das Maskenmuster sehr kompliziert ist und viele kleine, nahe beieinander liegende Öffnungen aufweist. Anders als bei der US-A-4 021 276 werden erst, wenn die dünne Schicht ihre endgültige Dicke erreicht hat, die Maskenöffnungen erzeugt, die — wiederum anders als bei der US-A-4 021 276 anschließend keinem Verfahrensschritt mehr unterworfen werden, in welchem sie unkontrolliert verändert werden, weshalb die Mustertreue innerhalb kleiner Toleranzen erreichbar ist. Das erfindungsgemäße Herstellungsverfahren ist aber auch geeignet, um der Maske die für die Herstellung hochintegrierter, dicht gepackter Schaltungen geeignete Struktur zu geben, wobei die notwendige mechanische Stabilität gewährleistet ist. Auch dann, wenn das Maskenmuster viele eng beieinanderliegende Öffnungen aufweist, hat die mit dem erfindungsgemäßen Verfahren hergestellte Maske eine so gute Stabilität, daß sie auch für die Herstellung hochintegrierter, d.h. relativ großflächige Chips bedeckende, Schaltungen benutzt werden kann, ohne daß im Chipbereich die Maske stabilisierende Verstärkungen, welche die optimale Anwendung der Maske verhindern würden, notwendig sind. So haben die nicht abgestützten Bereiche der erfindungsgemäßen Maske — den Chipgrößen entsprechende — laterale Abmessungen, welche bevorzugt zwischen etwa 1,25 und etwa 12,5 mm liegen. Dabei genügt es, damit die Maske auch bei so großen lateralen Abmessungen selbstunterstützend bleibt, daß die dünne Siliciumschicht eine Dicke im Bereich zwischen etwa 3 und etwa 5 $\mu$m aufweist. Schichtdicken dieser Größenordnung Können mit dem erfindungsgemäßen Verfahren sehr genau und reproduzierbar erzeugt werden. Die typische Dicke der aus dem verstärkenden Gerüst und der dünnen Schicht bestehenden Maskenstruktur liegt zwischen 0,127 und 0,318 mm, und solche Dicken haben auch die Siliciumsubstrate, von denen bei der Herstellung der Maske ausgegangen wird.

Es ist vorteilhaft, wenn ein einkristallines Siliciumplättchen mit einer <100>-Kristallorientierung verwendet wird, wenn die Siliciumschicht mit Bor dotiert und zum Ätzen des Substrats ein anisotrop ätzendes Agens eingesetzt wird, welches in der <100>-Richtung bevorzugt ätzt, so daß die Flanken der vom Substrat übrigbleibenden Rippen mit der dünnen Schicht einen Winkel von 54,7° bilden.

Anisotrop wird das Substrat bevorzugt mit einer Äthyllendiamin, Brenzkatechin und Wasser enthaltenden Mischung geätzt. Ein Silicium anisotrop ätzendes Mittel, welches Salpetersäure, Wasser, Flußsäure und Eissigsäure im Gewichtsverhältnis 100:20:4:110 enthält und welches dazu verwendet wird, trapezförmige Vertiefungen in Siliciumeinkristalle zu ätzen, ist aus der Französischen Patentschrift 22 52 907 bekant.

Im Unterschied zu Photolackmasken läßt sich die mittels des erfindungsgemäßen Verfahrens hergestellte Maske oft verwenden, wodurch Prozeßunregelmäßigkeiten, welche durch die voneinander abweichenden individuellen Fehler der einzelnen Photolackmasken hervorgerufen werden, wegfallen. Die erfindungsgemäße Maske erlaubt es auch — im Vergleich zu den auf Glasscheiben aufgebrachten Photolackmasken — die Fertigungstoleranzen zu verkleinern, da die mittels des erfindungsgemäßen Verfahrens hergestellte Maske zu der in der Produktion befindlichen Halbleiterschaltung genauer ausgerichtet werden kann, als dies mit den Photolackmasken möglich ist. Die erfindungsgemäßen Masken lassen sich praktisch bei allen Verfahrensschritten anwenden, bei welchem bei den bekannten Verfahren insbesondere zur Herstellung von integrierten Schaltungen Photolackmasken verwendet werden. Insbesondere ist die erfindungsgemäße Maske sehr vorteilhaft bei der Ionenimplantation, beim Kathodenzerstäubungsätzen — und zwar auch dann, wenn dabei Ionen eines reaktiven Gases der Gasatmosphäre zugefügt werden —, bei dem Abhebe (lift-off)-Verfahren zur Herstellung von Mustern aus Metallen oder isolierenden Materialien und auch bei Verfahrensschritten, bei denen auf das Kathodenzerstäubungsätzen unmittelbar ein Abhebeverfahren folgt. Zwar ist die Verwendung von Siliciummasken bei einzelnen dieser genannten Anwendungen beispielsweise bei der Ionen-implantation und beim Aufbringen von Metallisierungsmustern bereits aus den oben genannten US-Patentschriften und auch aus der FR-A-2 233 654 bekannt, jedoch handelt es sich dabei nicht um Anwendungen bei der Herstellung von hochintegrierten, dicht gepackten Schaltungen.

Weitere vorteilhafte Ausgestaltungen der Erfindung ergeben sich aus den Unteransprüchen.

Die Erfindung wird anhand von durch Zeichnungen erläuterten Ausführungsbeispielen beschrieben.

Es zeigen:

Fig. 1 in perspektivischer Darstellung einen Ausschnitt aus einem Teil einer siliciummaske, welche gemäß dem erfindungsgemäßen Verfahren hergestellt worden ist,

Fig. 1A in vergrößerter Darstellung einen Teil eines Schnittes durch die in der Fig. 1 gezeigte Maske,

Fig. 2A bis 2E Ausschnitte aus einer Maskenstruktur in verschiedenen Stadien der Herstellung gemäß einer bevorzugten Ausführungsform des erfindungsgemäßen Verfahrens,

Fig. 3 eine schematische Schnittansicht, welche den Gebrauch der Maske gemäß der vorliegenden Erfindung in einem Ionenimplantationsschritt bei der Herstellung integrierter Schaltkreise illustrieren soll;

Fig. 4 eine schematische Schnittansicht einer Maske gemäß der Erfindung, bei ihrer Anwendung als Ätzmaske bei der Herstellung von integrierten Schaltkreisen;

Fig. 5 eine schematische Schnittansicht der Maske gemäß der Erfindung, während ihrer Anwendung als Abhebe (lift-off)-Maske bei der Herstellung von Metallisierungsmustern aus abgeschiedenem Metall im rahmen der Herstellung von integrierten Schaltkreisen und

Fig. 6 und 6A in schematischen Schnittansichten eine Maske gemäß der Erfindung, während sie im Rahmen der Herstellung integrierter Schaltungen einerseits als Ätzmaske und andererseits als Maske beim Abscheiden von Metall benutzt wird.

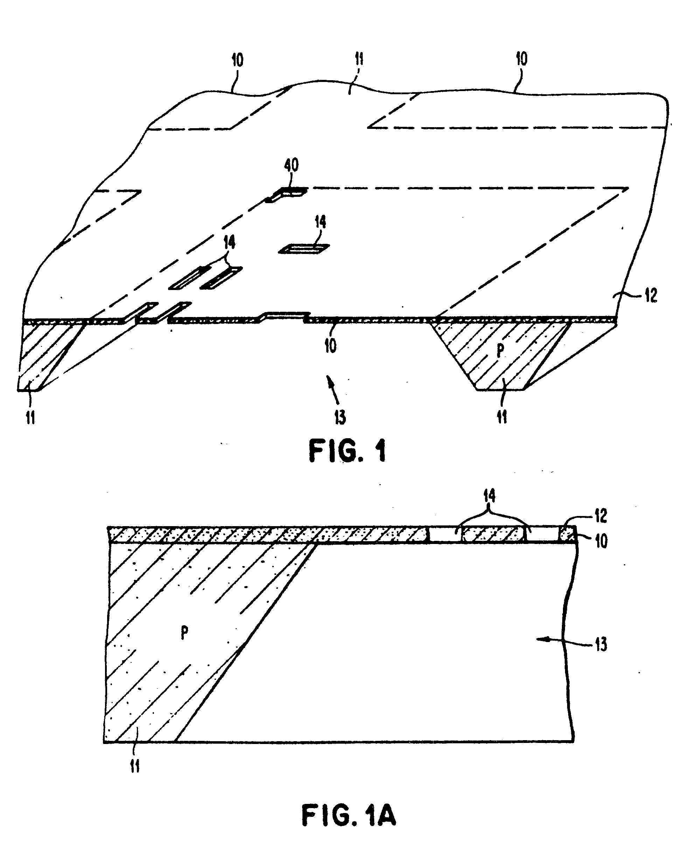

Die Figuren 1 und 1A zeigen einen Teil einer Siliciummaske, welche gemäß dem erfindungsgemäßen Verfahren hergestellt worden ist. Zu der Maske gehoren dünne Siliciumbereich 10, welche laterale Dimensionen in der Größenordnung von 12,7 mm aufweisen und damit im wesentlichen der Größe eines Chips auf einem Siliciumplättchen, welches dem Fabrikationsprozeß unterworfen wird, bei welchem eine Reihe von Masken, wie diejenigen, welche in den Figuren 1 und 1A gezeigt sind, benutzt werden, entsprechen. Zwischen der dunnen Siliciumbereichen 10 hat die Maske dickere, unterstützende Bereiche 11, welche bevorzugt in ihrem Abstand und in ihren Abmessungen denen der Schnittbereiche zwischen den Chips des Siliciumplättchens entsprechen, bei dessen Umwandlung in integrierte Schaltungen die Maske benutzt wird. Die dünne Siliciumschicht 10 hat eine Dicke, welche bevorzugt in der Größenordnung zwischen etwa 3 und etwa 5 $\mu$m liegt, während die Dicke der dickeren unterstützenden Bereiche oder Rippen 11 in der Größenordnung zwischen etwa 127 und etwa 381 $\mu$m liegt. Wie weiter unten im einzelnen besprochen wird, wird bei der Herstellung der integrierten Schaltungen die Maske mit der Oberfläche 12, welche im wesentlichen planar ist, während den Fabrikationsschritten, bei denen die Maske benutzt wird, kontaktierend auf die herzustellende integrierte Schaltung gelegt. Die dünne Maskierungsschicht 10 bildet dabei den Boden der Vertiefungen 13. Die Öffnungen 14 in der dünnen Siliciumschicht 10 dienen dazu, die Bereiche, auf welche bei der Operation bei der Herstellung von integrierten Schaltungen, bei der die vorliegende Maske benutzt wird, eingewirkt wird, zu definieren. Eine solche Operation kann unter anderem sein die Ionenimplantation, das Ätzen des Siliciumsubstrats oder von metallischen oder isolierenden Schichter auf dem Substrat und auch die Bildung von metallischen Mustern oder von Mustern aus elektrisch isolierendem Material auf dem Substrat mittels der Abhebe (lift-off)-Technik.

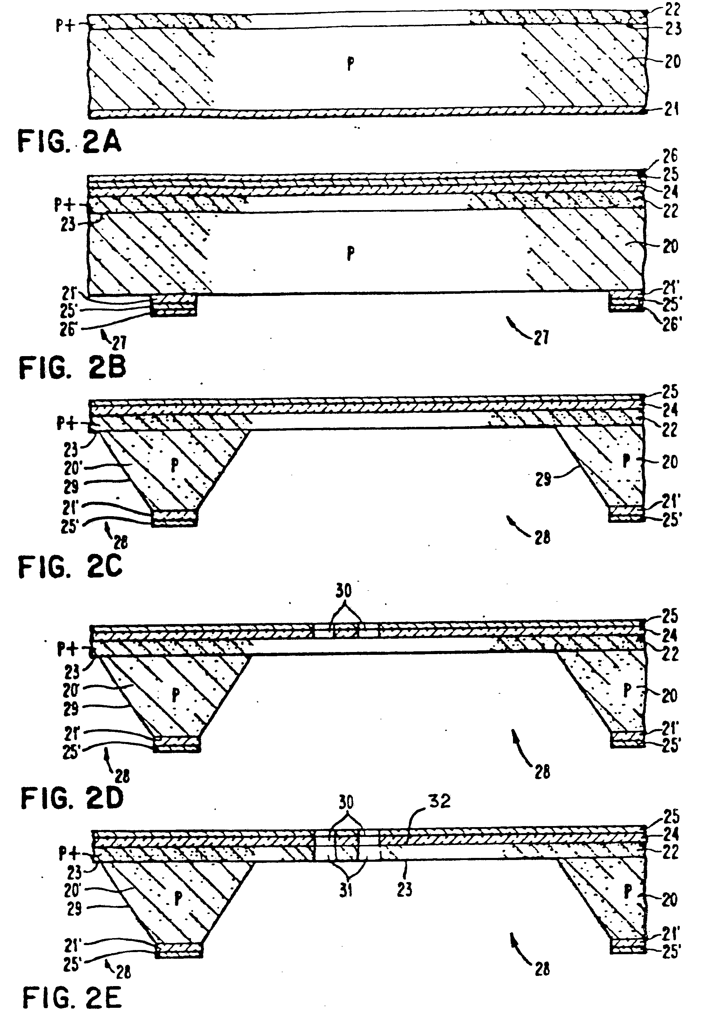

Anhand der Figuren 2A bis 2E soll nun das bevorzugte Herstellungsverfahren für die Maske gemäß der Erfindung beschrieben werden. Bei der Herstellung der Maske werden eine Reihe von lithographischen Maskierungsschritten durchgeführt, welche aber nicht im Detail besprochen werden, weil ihre Anwendung in der Halbleitertechnologie wohlbekannt ist. Einzelheiten solcher photolithographischer Maskierungs- und Herstellungsschritte können in den repräsentativen US-Patenten 3 589 876 und 3 904 454 und in dem Buch "Integrated Circuits, Design Principles and Fabrication" von R. M. Warner u.a., welches von der McGraw Hill Book Company 1965 veröffentlicht worden ist, nachgelesen werden.

Wie in der Fig. 2A gezeigt ist, wird auf einer eine<100>-kristallographische Orientierung auf-weisende Oberfläche eines Siliciumsubstrats 20 vom P-Typ, welches einen spezifischen Widerstand von 10 $\Omega$ cm hat, mittels thermischer Oxydation eine etwa 500 nm dicke Siliciumdioxidschicht 21 aufgewachsen. Diese Schicht dient als diffusionshindernde Maske. Dann wird die andere Oberfläche des Substrats einer etwa 64 Stunden dauernden und bei 1100°C durchgeführten Borkapseldiffusion unterworfen, um eine höher dotierte Siliciumschicht 22 des P$^+$-Typs zu erzeugen, welche eine Oberflächen-konzentration $C_0$ von 3 $\times$ 10$^{20}$ Atomen/cm$^3$ und an der Grenzschicht 23 eine Dotierungskonzentration von 7 $\times$ 10$^{19}$ Atomen/cm$^3$ aufweist.

Als nächstes wird, wie die Fig. 2B zeigt, eine Schicht 24 aus Siliciumdioxid, welche etwa 500 nm dick ist, über der Siliciumschicht 22 von P$^+$-Type erzeugt. Es sollte angemerkt werden, daß die P$^+$-Schicht 22 etwa 5 $\mu$m dick ist. Wenn wie im vorliegenden Beispiel die P$^+$-Schicht 22, welche später der dünne Bereich der Silicummaske werden soll, 5 $\mu$m oder dünner ist, sollte die Siliciumdioxidschicht 24 nicht durch thermische Oxydation, sondern durch ein anderes Verfahren erzeugt werden. Wenn man beim Vorliegen einer so dünnen Schicht thermisch oxydieren würde, würde der dünne Siliciumbereich der Maske, welcher aus der P$^+$-Schicht 22 erzeugt wird, vor allem dann, wenn er große laterale Abmessungen, d.h. solche in der Größenordnung zwischen 1,27 und 12,7 mm, zwischen den Rippen aufweist, verformt werden. Infolgedessen wird die Siliciumdioxidschicht 24 bevorzugt mittels einer nichtthermischen Aufwachstechnik, wie z.B. mittels der konventionellen Kathodenzerstäubung oder des konventionellen chemischen Niederschlagens aus der Dampfphase, erzeugt.

Als nächstes werden eine Siliciumnitridschicht 25, welche etwa 100 nm dick ist und eine Schicht 26 aus Siliciumdioxid, welche auch etwa 100 nm dick ist, in bekannter Art und Weise auf dem Siliciumplättchen abgeschieden. Gleichzeitig werden die Siliciumnitridschicht 25' und die Siliciumdioxidschicht 26' auf der unteren Siliciumdioxidschicht 21 abgeschieden. Anschließend wird mittels bekannter photolithographischer Ätztechniken eine zusammengesetzte Maske aus den Schichten 21', 25' und 26' auf der Unterseite des Substrats 20 erzeugt. Die Öffnungen 27 in dieser Maske dienen dazu, das Muster der Vertiefungen 28, welche in dem folgenden, in der Fig. 2C veranschaulichten Verfahrensschritt im Substrat erzeugt werden sollen, zu definieren.

Die Vertiefungen 28 werden im Substrat 20 mittels einer anisotropen Ätztechnik erzeugt, bei welcher das weniger stark dotierte P-Substrat 20 selektiv weggeätzt wird und das Ätzen an der unteren Oberfläche 23 der P$^+$-Schicht 22 praktisch stoppt. Das anisotrope Ätzen dient dazu, das unerwünschte laterale Ätzen, welches sonst beträchtlich wäre, wenn durch ein Siliciumsubstrat, welches eine Dicke zwischen etwa 127 und etwa 381 $\mu$m hat, geätzt wird, auf ein Minimum zu reduzieren. Beim anisotropen Ätzen zur Erzeugung der Vertiefungen 28 wird eine Mischung aus Äthylendiamin, Brenzkatechin und Wasser verwendet. Beispielsweise kann eine Mischung, welche 25 ml Äthylendiamin, 4 g Brenzkatechin und 4 ml Wasser enthält bei 118°C benutzt werden, wobei man zur Verhinderung der Oxidation Stickstoff durch die Lösung blubbern läßt. Eine solche Mischung ätzt mit Bor schwach dotiertes Silicium, aus welchem beispielsweise das Substrat 20 besteht, selektiv während stark mit Bor dotiertes Silicium, aus welchem beispielsweise die P$^+$-Schicht 22 besteht, bei dem Ätzen im wesentlichen unverändert erhalten bleibt. Da diese Mischung so ätzt, daß die übrigbleibenden maskierten Siliciumripper 20' — sofern das Silicium eine <100>-kristallographische Orientierung hat — einen Winkel 29 von 54,7° mit der Horizontalen bildet, wird das unerwunschte laterale Ätzen ganz begrenzt sein. Einzelheiten des Ätzens mit der Äthylendiamin-Brenzkatechin-Wasser-Mischung können einem Artikel in den IEEE Transactions on Electronic Development, Band ED23, Nr. 6, Juni 1976, Seiten 579 — 583 entnommen werden.

Dann wird, wie die Fig. 2D zeigt, unter Anwendung von in der Halbleitertechnik üblicher photolithographischer Fabrikationstechniken ein Muster von Öffnungen 30 durch die Siliciumnitridschicht 24 und die Siliciumdioxidschicht 25 hindurch erzeugt. Das Muster von Öffnunger 30 entspricht dem Muster von Öffnungen, welche in der Siliciummaske erzeugt werden sollen. Dann wird, wie die Fig. 2E zeigt, das entsprechende Muster von Öffnunger 31 durch die dünne P$^+$-Schicht 22 hindurch geätzt. Zum Ätzen der Öffnungen durch die P$^+$-Schicht 22 hindurch können in der Halbleitertechnik übliche Siliciumätzverfahren, wie z.B. das Ätzen mit einer Mischung aus verdünnter Flußsäure und Salpetersäure angewandt werden. Da jedoch die P$^+$-Schicht 22, welche durchgeätzt werden muß, relativ dick, d.h. in der Größenordnung von 3 bis 5 $\mu$m, ist, ist es wünschenswert, das laterale Ätzen auf ein Minimum zu reduzieren. Deshalb wird es bevorzugt, die Öffnungen 31 durch die P$^+$-Schicht 22 mittels des Kathodenzerstäubungsätzens, wobei übliche Kathodenzerstäubungsätzvorrichtungen und -methoden, wie sie beispielsweise in dem US-Patent 3 598 710 beschrieben sind, und insbesondere mittels des Kathondenzerstäubungsätzens unter Zugabe von reaktiven Gasen zu ätzen. Im US-Patent 3 471 396 ist eine Liste von inerten oder reaktiven Gasen oder Kombinationen solcher Gase enthalten, welche beim Kathodenzerstäubungsätzen benutzt werden können. Eine bevorzugte reaktive Kathodenzerstäubungsätzatmosphäre ist z.B. ein Cl$_2$-Plasma.

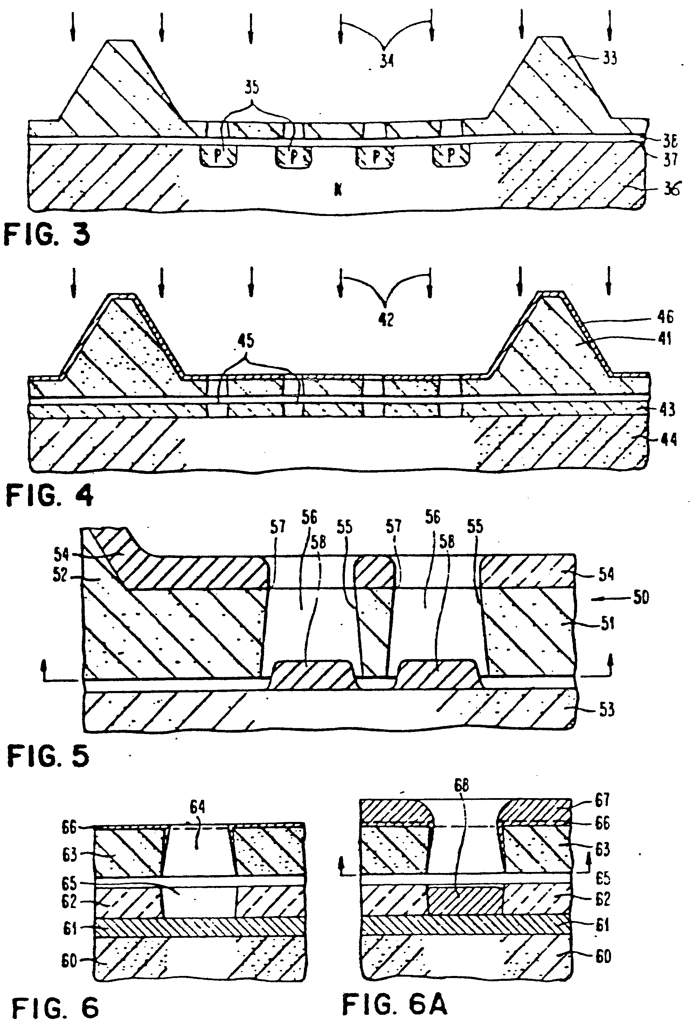

Zur Erzielung der besten Ergebnisse, wird es bei der Durchführung des erfindungsgemäßen Verfahrens bevorzugt, die Öffnungen 31, wie es die Fig. 2E zeigt, von der Oberfläche 32 der P$^+$-Schicht 22 ausgehend und nicht von der unteren Oberfläche 23 der P$^+$-Schicht 22 ausgehend zu ätzen. Das Ätzen, wie es die Fig. 2E zeigt, wird eine Öffnung 31 erzeugen, deren Seitenwände sich zum unteren Rand der Öffnung hin mit einem Winkel von etwa 5° verjüngen. Wie weiter unten bei der Beschreibung anhand der Figuren 5 und 6A gezeigt werden wird, ist eine solche Verjüngung insbesondere deshalb wünschenswert, weil dann, wenn die Maske in einem Abhebe-Verfahrensschritt bei der Herstellung von metallischen oder anderen Mustern auf dem Substrat benutzt wird, ein Überhang bzw. ein negativer Abhang in den Maskenöffnungen vorhanden ist.

In jedem Fall ist es wünschenswert, daß, wenn die Erzeugung des Musters von Öffnungen 31, wie es die Fig. 2E zeigt, abgeschlossen ist, die Siliciumdioxidschichten 21 und 24 und die Siliciumnitridschichten 25 und 25' entfernt werden, wodurch die sich selbst unterstützende Siliciummaske übrig bleibt. Das Muster von Öffnungen 31 in dieser Maske entspricht einem speziellen lateralen Muster, welches die Bereiche definiert, welche während eines speziellen Verfahrensschritts im Laufe der Herstellung der integrierten Schaltung selektiv verändert werden. Zu diesen Verfahrensschritten gehören die Einführung von Verunreinigungen in das Substrat, das Ätzen von metallischen oder isolierenden Schichten oder von Mustern in das Substrat, die selektive Oxydation des Substrats oder das Abscheiden von metallischen oder isolierenden Mustern auf dem Substrat mittels der Abhebe(lift-off)-Technik. Repräsentative Beispiele einiger dieser Verfahren, bei denen die erfindungsgemäße Siliciummaske im Laufe der Herstellung von integrierten Schaltungen benutzt wird, sollen nun beschrieben werden.

In der Fig. 3 ist die Anwendung der Siliciummaske 33 als Maske beim Implantieren von positiven Borionen mittels des Ionenstrahls 34 gezeigt, wobei Bereiche 35 vom P-Typ in dem Substrat 36 vom N-Typ erzeugt werden. Die Maske 33 liegt bündig auf der Oberfläche 37 des Substrats 36. Jedoch wird auch bei einem solchen bündigen Kontakt wegen der unvermeidlichen Oberflächenunregelmäßigkeiten im Normalfall ein Abstand 38, dessen Dicke zwischen etwa 400 und etwa 1000 nm liegt, das Substrat von der Maske 33 trennen. Wegen des im wesentlichen bündigen Kontakts ist die Ausrichtung von Ausrichtungsmarken auf der Maske, wie z.B. die L-förmige Ausrichtungsmarke 40 in der Fig. 1, mit dem Substrat mittels optischer Mittel stark erleichtert, da die Ausrichtungsmarke höchstens einige $\mu$m von einem entsprechenden (nicht gezeigten) Ausrichtungsindikator auf dem Substrat entfernt ist. Es kommt hinzu, daß mit dieser Anordnung alle Maskenausrichtungsprobleme, welche typisch sind für das Ausrichten von Photolackmasken in photolithographischen Verfahrensschritten bei der Herstellung von integrierten Schaltungen (siehe dazu die Ausführungen zum Stand der Technik in der Beschreibungseinleitung) gemildert oder eliminiert werden. Als Folge davon, werden mit den erfindungsgemäßen Siliciummasken Ausrichtungstoleranzen bezüglich des Substrats in der Größenordnung von $\pm 0,5$ $\mu$m möglich, während bei der bekannten Ausrichtung von Photolackmasken die Ausrichtungstoleranzen bei $\pm 2$ $\mu$m liegen. Infolgedessen variieren bei der Anwendung der erfindungsgemäßen Maske durch Ionenimplantation erzeugte Widerstände, wie z.B. die Widerstände 35 in der Fig. 3, weniger in ihren lateralen Abmessungen als bei der Verwendung der bekannten Masken, und es ist mit den erfindungsgemäßen Masken möglich, Widerstände herzustellen, deren Parameter innerhalb sehr enger Toleranzen liegen.

In der Fig. 4 ist die Anwendung der Siliciummaske 41 als Maske bei einer Kathodenzerstäubungsätzoperation in einem Hochfrequenzkathodenzerstäubungssystem gezeigt, bei der die Ionen 42, welche reaktive Ionen einschließen, auf eine Isolierschicht 43 auf einem Substrat 44 für eine integrierte Schaltung gerichtet wird, um eine Vielzahl von Öffnungen 45 durch diese Isolierschicht zu ätzen. Das Hochfrequenzkathodenzerstäubungssystem, welches unter Anwendung reaktiver Ionen arbeitet, kann dasselbe bekannte System sein, welches weiter oben im Zusammenhang mit der Herstellung von Siliciummasken beschrieben worden ist. Wird die Siliciummaske als Maske in einem Hochfrequenzkathodenzerstäubungssystem, insbesondere einem solchen, welches unter Anwendung von reaktiven Ionen arbeitet, verwendet, so ist es als wünschenswert erkannt worden, daß die Siliciummaske mit einer dünnen Schicht 46, welche größenordnungsmäßig 200 nm dick ist, aus einem beschützenden Metall, wie z.B. aus Aluminium, beschichtet wird. Diese Beschichtung kann in bekannter Weise aufgebracht werden, nachdem die schützenden Schichten aus isolierendem Material, welche in Verbindung mit dem anhand der Fig. 2A erläuterten Maskenöffnungsverfahrensschritts verwendet worden sind, entfernt worden sind.

Die erfindungsgemäße selbstunterstützende Siliciummaske ist ein wertvolles Hilfsmittel bei einer solchen Herstellung von integrierten Schaltungen, welche Verfahrensschritte einschließt, bei welchen Muster entweder aus elektrisch isolierendem Material oder aus Metall auf einem Substrat durch die Öffnungen in einer Maske abgeschieden und dann die Maske abgehoben wird, um überschüssiges Material zu entfernen. Ein solcher Verfahrensschritt ist in der Fig. 5 gezeigt. In dem Ausschnitt aus der Siliciummaske 50 sind die dünne Siliciumschicht 51 der Maske und dicke der Bereiche der unterstützenden Maskenrippen 52 zu erkennen. Die dünne Siliciumschicht 51 der Maske liegt kontaktierend auf dem Substrat 53, auf welchem ein Metallisierungsmuster erzeugt werden soll, und eine ganzflächige Metallabscheidung, wie die Aluminiumschicht 54 ist über dem ganzen maskierten Substrat aufgebracht. Weil, wie weiter oben beschrieben worden ist, die Seitenwände 55 der Öffnungen 56 in der Maske einen leichten negativen Abhang haben, was einen Maskenüberhang oder eine Maskenlippe 57 am Rand der Maskenöffnungen 56 bewirkt, sind alle Voraussetzungen, welche in der Abhebe-Technik als notwendig erkannt worden sind, vorhanden, um zu verhindern, daß das Metallmuster 58 derart in den Öffnungen abgeschieden wird, daß es in das auf der Maskenoberfläche abgeschiedene Metall 54 kontinuierlich übergeht. Dank dieser Diskontinuität kann die Maske 51 leicht abgehoben werden, wobei sie die abgeschiedene, durchgehende Aluminiumschicht 54 mitnimmt und das Aluminiummuster 58, welches dem Muster der Öffnungen 56 entspricht, zurückläßt. Nach dem Abschluß des Verfahrensschritts kann die Metallschicht 54 selektiv von der Maske 50 entfernt werden und die Maske kann für dieselbe Operation bei einem anderen Plättchen für integrierte Schaltungen wiederbenutzt werden.

In den Figuren 6 und 6A ist ein Teil einer Siliciummaske gezeigt, um die Anwendung der Maske für eine Kombination von Verfahrensschritten, d.h. für das Kathodenzerstäubungsätzen eines Substrats unter Anwendung von reaktiven Ionen und die anschließende Abscheidung eines Metallmusters in den geätzten Bereichen des Substrats, zu illustrieren. In der Fig. 6 ist ein Substrat 60 gezeigt, auf welchem eine Metallschicht 61 und darüber eine Isolierschicht 62 aufgebracht sind. Die Siliciummaske 63 ist kontaktierend auf die Isolierschicht 62 gelegt.

6

**0 001 038**

Zur Vereinfachung der Darstellung ist von der Maske 63 nur die dünne Siliciumschicht der Maske und eine in diese eingebrachte Öffnung 64 zu sehen. Mittels eines Kathodenzerstäubungsätzschrittes, bei dem, wie es oben anhand der Fig. 4 beschrieben worden ist, reaktive Ionen angewandt werden, wird dann ein Muster von Öffnungen 65, welche den Maskenöffnungen 64 entsprechen, durch die Isolierschicht 62, welche aus einem Material wie z.B.

Siliciumdioxid bestehen kann, mittels Kathodenzerstäubungsätzens hindurchgeätzt. Um beste Ergebnisse zu erzielen, wird bei einem solchen Kathodenzerstäubungsverfahrensschritt die Siliciummaske 63, wie es im Zusammenhang mit der Fig. 4 beschrieben worden ist, vor der Anwendung der Maske in dem Kathodenzerstäubungsätzschritt bevorzugt mit einer dünnen Aluminiumschicht 66 beschichtet. Das Ergebnis zeigt die Fig. 6.

Dann wird in derselben Weise, wie es im Zusammenhang mit der Fig. 5 besprochen worden ist, Metall abgeschieden, um ein Muster von metallischen Verbindungen 68 in den Öffnungen 65, welche sich durch die Isolierschicht 62 erstrecken, zu erzeugen. Die Verbindungen 68 haben die Aufgabe, Verbindungen zu der darunterliegenden Metallschicht 61 herzustellen. Der Rest der ganzflächig aufgebrachten Metallabscheidung 67 wird entfernt, indem die Siliciummaske 63 abgehoben wird.

## Patentansprüche

1. Verfahren zum Herstellen einer Maske aus Silicium, bei dem an der einen Oberfläche eines plättchenförmigen und planaren Substrats (20) aus Silicium eine dünne Siliciumschicht (22) erzeugt wird, deren Konzentration an die Leitfähigkeit bestimmenden Verunreinigungen höher als im Substrat (20) ist und bei dem von der Substratoberfläche her, welche der höher dotierten Siliciumschicht (22) entgegengesetzt ist, selektiv in das Substrat (20) hinein Vertiefungen (13, 28) geätzt werden und bei dem von der Oberfläche der dünnen, höher dotierten Siliciumschicht (22) aus selektiv entsprechend dem gewünschten Maskenmuster bis zu dem beim Ätzen des Substrats entstandenen Vertiefungen durchgehende Löcher (14, 31) geätzt werden, dadurch gekennzeichnet, daß vor dem Ätzen des Maskenmusters in die dünne, höher dotierte Siliciumschicht (22) die Vertiefungen (13, 28) erzeugt werden, indem mit einem Mittel, welches schwach dotiertes Silicium schneller als hoch dotiertes Silicium angreift, das Substratmaterial bis zu der dünnen, höher dotierten Siliciumschicht (22) weggeätzt wird.

2. Verfahren nach Anspruch 1, dadurch gekennzeichnet, daß die Abmessungen der Vertiefungen (28) so festgelegt werden, daß die Abstände zwischen den verbleibenden benachbarten, einander gegenüberliegenden Rippen (20') des Substrats (20) zwischen ungefähr 1,25 und ungefähr 12,5 mm betragen und die zugehörigen minimalen Dicken der höher dotierten Siliciumschicht (22) zwischen etwa 3 und etwa 5 $\mu$m liegen.

3. Verfahren nach Anspruch 1 oder 2, dadurch gekennzeichnet, daß als Substrat (20) ein einkristallines Siliciumplättchen mit einer <100>-Kristallorientierung verwendet wird, daß die höher dotierte siliciumschicht (22) durch dotieren mit Bor hergestellt wird und daß beim Ätzen des Substrats (20) ein anisotrop ätzendes Agens eingesetzt wird, welches in der Weise in der <100>-Richtung bevorzugt ätzt, daß die Flanken der vom Substrat (20) beim Ätzen übrigbleibenden Rippen (20') mit der höher dotierten Siliciumschicht (22) einen Winkel von 54,7° bilden.

4. Verfahren nach Anspruch 3, dadurch gekennzeichnet, daß das Substrat mit einer Äthylendiamin, Brenzkatechin und Wasser enthaltenden Mischung geätzt wird.

5. Verfahren nach einem oder mehreren der Ansprüche 1 bis 4, dadurch gekennzeichnet, daß die dem Maskenmuster entsprechenden Löcher (31) mittels Kathodenzerstäubungsätzens erzeugt werden, wobei unter Umständen der Gasatmosphäre Ionen eines reaktiven Gases zugefügt werden.

6. Verfahren nach einem oder mehreren der Ansprüche 1 bis 5, dadurch gekennzeichnet, daß die höher dotierte Siliciumschicht (22) unter solchen Bedingungen geätzt wird, daß sich die Löcher (31) in Richtung der Vertiefungen 28 verjüngen.

7. Verfahren nach einem oder mehreren der Ansprüche 1 bis 6, dadurch gekennzeichnet, daß nach der Erzeugung der dünnen, höher dotierten Siliciumschicht (22) auf der Oberfläche dieser Schicht eine Siliciumdioxidschicht (24) unter Vermeidung hoher Temperaturen erzeugt wird, und daß vor dem Ätzen der dünnen, höher dotierten Siliciumschicht (22) in die Siliciumdioxidschicht (24) ein dem gewünschten Maskenmuster entsprechendes Muster derart geätzt wird, daß in den entstandenen Vertiefungen (30) die dünne, höher dotierte Siliciumschicht (22) freiliegt.

8. Verfahren nach einem oder mehreren der Ansprüche 1 bis 7, dadurch gekennzeichnet, daß die Maskenoberfläche mit einer Metallschicht (46, 66), beispielsweise aus Aluminium, bedeckt wird.

9. Verwendung einer Maske nach einem oder mehreren der Ansprüche 1 bis 8, dadurch gekennzeichnet, daß die Maske bei Operationen, bei denen die Eigenschaften von Bereichen der Oberfläche eines Gegenstandes verändert werden sollen, eingesetzt wird, wobei die Maske mit der höher dotierten Siliciumschicht kontaktierend auf die Oberfläche des Gegenstandes gelegt wird, dann die freiliegenden Oberflächenbereiche der Operation bzw. den Operationen unterworfen werden und schließlich die Maske wieder von der Oberfläche des Gegenstandes abgehoben wird.

10. Verwendung nach Anspruch 9, dadurch gekennzeichnet, daß die Maske bei der Herstellung

7

integrierter Schaltungen eingesetzt wird, daß es sich bei dem Gegenstand um ein Halbleitersubstrat (36, 44) bzw. um eine Schicht (53, 61) auf einem Halbleitersubstrat handelt, daß die Abmessungen der Maske (33, 41, 51, 52, 63) derart auf die Abmessungen der Bereiche auf dem Halbleitersubstrat (30, 44) bzw. der Schicht (53, 61) abgestimmt sind, daß die Bereiche der dünnen, höher dotierten Siliciumschicht (51, 63) etwa die Größe der Halbleiterchips haben und das Rippengerüst (33, 41, 52) so ausgebildet ist, daß es mit den Bereichen des Halbleitersubstrats (36, 44) bzw. der Schicht (53, 61), welche beim Zerschneiden in Halbleiterchips wegfallen zur Deckung gebracht werden kann und daß die Operationen, bei denen die Eigenschaften von Bereichen der Oberfläche des Halbleitersubstrats (36, 44) bzw. der Schicht (53, 61) verändert werden sollen, alle Verfahrensschritte umfassen, bei welchen bei den bekannten Verfahren Photolackmasken üblicherweise eingesetzt werden.

11. Verwendung nach Anspruch 9 oder 10, dadurch gekennzeichnet, daß es sich bei der Operation um einem Verfahrensschritt aus der Gruppe selektives Implantieren von Ionen in ein Halbleitersubstrat, Kathodenzerstäubungsätzen, bei dem Vertiefungen in ein Halbleitersubstrat, in eine Metallschicht oder in eine Schicht aus einem isolierenden Material geätzt wird, Kathodenzerstäubungsätzen in Gegenwart von Ionen eines reaktiven Gases, bei dem Vertiefungen in ein Halbleitersubstrat, in eine Metallschicht oder in eine Schicht (43) aus einem isolierenden Material geätzt wird und Abhebe-Verfahren zum Aufbringen von Mustern (58) aus einem Metall oder aus einem isolierenden Material bzw. um zwei aufeinanderfolgende Verfahrensschritte handelt, bei denen zunächst mittels Kathodenzerstäubungsätzens Vertiefungen (65) entsprechend einem gewünschten Muster geätzt werden und dann in den Vertiefungen (65) mittels des Abhebeverfahrens das gewünschte Muster (68) aus einem Metal oder aus einem isolierenden Material erzeugt wird.

**Revendications**

1. Procédé de fabrication d'un masque de silicium, dans lequel on produit sur une surface d'un substrat de silicium planaire en forme de tranche (20) une couche mince de silicium (22) ayant une concentration d'impuretés déterminant la conductivité plus élevée que le substrat (20), dans lequel on décape sélectivement, à partir de la surface de substrat opposée à la couche de silicium à dopage plus élevé (22), des creux dans le substrat (20), et dans laquelle on décape sélectivement sur la configuration de masque désirée des trous de traversée (14, 31) de la surface de la couchè de silicium mince à dopage plus élevé (22) jusqu'aux creux obtenus par décapage du substrat, caractérisée en ce qu'avant de décaper la configuration de masque dans la couche de silicium mince à dopage plus élevé (22) on obtient les creux (28) en décapant le matériau de substrat jusqu'à la couche de silicium mince à dopage plus élevé (22) à l'aide d'un moyen qui attaque le silicium faiblement dopé plus rapidement que le silicium fortement dopé.

2. Procédé selon la revendication 1, caractérisé en ce que les dimensions des creux (28) sont tels que les espacements entre les barres restantes adjacentes (20') du substrat (20) qui se font face sont entre environ 1,25 et environ 12,5 mm et que les épaisseurs minimum correspondantes de la couche de silicium plus fortement dopée (22) est d'environ 3 à environ 5 $\mu$m.

3. Procédé selon l'une quelconque des revendications 1 ou 2, caractérisé en ce que le substrat utilisé (20) est une tranche de silicium monocristallin ayant une orientation cristallographique <100>, que l'on produit la couche de silicium à dopage plus élevé (22) par un dopage aù bore, et que l'on utilise pour le décapage du substrat (20) un décapant anisotrope qui, de préférence, décape dans la direction <100> de sorte que les côtés des barres (20') restantes du substrat (20) après décapage forment un angle de 54,7° avec la couche de silicium (22) à dopage plus élevé.

4. Procédé selon la revendication 3, caractérisé en ce que le substrat est décapé avec un mélange contenant de l'éthylène-diamine, de la pyrocatéchine et de l'eau.

5. Procédé selon l'une quelconque ou plusieurs des revendications 1 à 4, caractérisé en ce que les trous (31) correspondant à la configuration de masque sont produits par décapage par pulvérisation cathodique, des ions d'un gaz réactif pouvant éventuellement être ajoutés à l'atmosphère gazeuse.

6. Procédé selon l'une quelconque ou plusieurs des revendications 1 à 5, caractérisé en ce que la couche de silicium (22) à dopage plus élevé est décapée de façon que les trous (31) rétrécissent dans la direction des creux (28).

7. Procédé selon l'une quelconque ou plusieurs des revendications 1 à 6, caractérisé en ce qu'après formation de la couche de silicium mince (22) à dopage plus élevé on produit sur la surface de cete couche une couche de dioxyde de silicium (24) en évitant des températures élevées, et qu'avant le décapage de la couche de silicium mince (22) à dopage plus élevé on décape dans la couche de dioxyde de silicium (24) une configuration correspondant à la configuration de masque désirée de telle sorte que la couche de silicium mince (22) à dopage plus élevé soit exposé dans les creux (30) ainsi formés.

8. Procédé selon l'une quelconque ou plusieurs des revendications 1 à 7, caractérisé en ce que l'on dépose sur la surface du masque une couche de métal (46, 66) composée, par exemple, d'aluminium.

9. Application d'un masque selon l'une quelconque ou plusieurs des revendications 1 à 8, caractérisé en ce que le masque est utilisé pour des opérations modifiant les caractéristiques des régions de surface d'un objet, en déposant le masque avec la couche de silicium plus fortement dopée en contact sur la surface de l'objet, en soumettant ensuite les régions de surface exposées à l'opération ou aux opérations, et en enlevant enfin le masque de la surface de l'objet.

10. Application selon la revendication 9, caractérisée en ce que le masque est utilisé dans la fabrication des circuits intégrés, que l'objet est un substrat semi-conducteur (36, 44) ou une couche (53, 61) sur un substrat semiconducteur, que les dimensions du masque (33, 41, 51, 52, 63) sont adaptées aux dimensions des régions sur le substrat semi-conducteur (40, 44) ou la couche (53, 61) de sorte que les régions de la couche de silicium mince (51, 63) à dopage plus élevé ont à peu près la dimension des microplaquettes semi-conductrices et que la structure des barres (33, 41, 52) est conçue de façon à coïncider avec les régions du substrat semi-conducteur (36, 44) ou de la couche (53, 61), qui sont supprimées lors du découpage en microplaquette semi-conductrices, et que les opérations visant à modifier les caractéristiques des régions de la surface du substrat semi-conducteur (36, 44) ou de la couche (53, 61) comportent toutes les étapes qui utilisent habituellement des masques photorésistants dans les procédés connus.

11. Application selon la revendication 9 ou 10, caractérisée en ce que l'opération est constituée par une étape de procédé du groupe comportant l'implantation sélective d'ions dans un substrat semi-conducteur, le décapage par pulvérisation cathodique pour décaper des creux dans un substrat semi-conducteur, dans une couche de métal, ou dans une couche de matériau isolant, de décapage par pulvérisation cathodique en présence d'ions d'un gaz réactif pour décaper des creux dans un substrat semi-conducteur, dans une couche de métal, ou dans une couche (43) d'un matériau isolant, et un procédé d'enlèvement pour le dépôt de configurations (58) d'un métal ou d'un matériau isolant, ou en ce que l'opération est constituée par deux étapes de procédé successives pour décaper d'abord par décapage par pulvérisation cathodique des creux (65) selon une configuration désirée, et pour produire ensuite dans les creux (65), au moyen du procédé d'enlèvement, la configuration (68) désirée comportant du métal ou un matériau isolant.

**Claims**

1. Method of making a silicon mask wherein on one surface of a wafer-shaped and planar silicon substrate (20) a thin silicon layer (22) is produced whose concentration of conductivity-determining impurities is higher than in the substrate (20), wherein recesses (28) are selectively etched into the surface of the substrate (20) opposite the silicon layer (22) of higher doping, and wherein from the surface of the thin silicon layer (22) of higher doping, in accordance with the desired mask pattern, holes (14, 31) are selectively etched down to the recesses produced by the substrate etching, characterized in that prior to the etching of the mask pattern into the thin silicon layer (22) of higher doping the recesses (28) are produced with means which attacks silicon of low doping concentration quicker than highly doped silicon, the substrate material being etched fully through to the thin silicon layer (22) of higher doping.

2. Method as claimed in claim 1, characterized in that the dimensions of the recesses (28) are such that the distances between remaining, adjacent ribs (20') of the substrate (20) facing each other are approximately between 1.25 and approximately 12.5 mm, and that the thickness of the silicon layer (22) of higher doping is between approximately 3 and approximately 5 $\mu$m.

3. Method as claimed in claim 1 or 2, characterized in that the substrate (20) comprises a monocrystalline silicon wafer with a <100> crystal orientation, that the silicon layer (22) of higher doping is produced through boron-doping, and that for etching the substrate (20) an anisotropic etchant is used which preferentially etches in the <100> direction in such a manner that the sides of the ribs (20') remaining of the substrate (20) after etching form with the silicon layer (22) of higher doping an angle of 54.7°.

4. Method as claimed in claim 3, characterized in that the substrate is etched with a mixture containing ethylene diamine, pyrocatechol and water.

5. Method as claimed in one or several of claims 1 to 4, characterized in that the holes (31) corresponding to the mask pattern are made by means of cathode sputter etching, ions of a reactive gas being added to the gaseous atmosphere, if necessary.

6. Method as claimed in one or several of claims 1 to 5, characterized in that the silicon layer (22) of higher doping is etched under conditions in which the holes (31) taper in the direction of the recesses (28).

7. Method as claimed in one or several of claims 1 to 6, characterized in that after the thin silicon layer (22) of higher doping has been made, a silicon dioxide layer (24) is produced on the surface of said layer, with high temperatures being avoided, and that prior to the etching of the thin silicon layer (22) of higher doping in the silicon dioxide layer (24) a pattern corresponding to the desired mask pattern is etched in such a manner that the thin silicon layer (22) of higher doping is exposed in the recesses (30) formed.

8. Method as claimed in one or several of claims 1 to 7, characterized in that the mask surface is covered with a metallic layer (46, 66), e.g. of aluminium.

9

9. Use of a mask as claimed on one or several of claims 1 to 8, characterized in that the mask is used in operations which are to alter the characteristics of surface areas of an object, the mask with the silicon layer of higher doping being placed on the object surface in contact therewith, the exposed surface areas being subjected to the operation or operations, and the mask being finally lifted off again from the object surface.

10. Use as claimed in claim 9, characterized in that the mask is used in the production of integrated circuits, that the object is a semiconductor substrate (36, 44) or a layer (53, 61) on a semiconductor substrate, that the mask dimensions (33, 41, 51, 52, 63) are adapted to the dimensions of the areas on the semiconductor substrate (30, 44), or the layer (53, 61) in such a manner that the areas of the thin silicon layer (51, 63) of higher doping are approximately of the size of the semiconductor chips, and the rib frame (33, 41, 52) is designed in such a manner that it can be made to coincide with those areas of the semiconductor substrate (36, 44) or of the layer (53, 61) which are cut off in the dicing process of the semiconductor chips, and that the operations which are to alter the characteristics of surface areas of the semiconductor substrate (36, 44), or of the layer (53, 61) comprise the process steps in which the known methods generally use photoresist masks.

11. Method as claimed in claim 9 or 10, characterized in that the operation is a process step of the group of selective implanting of ions into a semiconductor substrate, cathode sputter etching by means of which recesses are etched into a semiconductor substrate, into a metallic layer, or into a layer of an insulating material, cathode sputter etching in the presence of ions of a reactive gas by means of which recesses are etched into a semiconductor substrate, into a metallic layer, or into a layer (43) of an insulating material, and lift-off methods for applying patterns (58) of a metal or an insulating material, or that it consists of two successive process steps in which first by cathode sputter etching recesses (65) are etched in accordance with a desired pattern, and which subsequently in the recesses (65), by means of the lift-off method, the desired pattern (68) is produced out of a metal or an insulating material.

FIG. 1

FIG. 1A

FIG. 2A

FIG. 2B

FIG. 2C

FIG. 2D

FIG. 2E

**FIG. 3**

**FIG. 4**

**FIG. 5**

**FIG. 6**

**FIG. 6A**